# EUROPEAN PATENT SPECIFICATION

(11) **EP 0 425 088 B1**
(45) Date of publication and mention of the grant of the patent: **19.04.1995**
(21) Application number: 90310133.5
(22) Date of filing: 17.09.1990
(51) Int. Cl.: G11C 13/04, G03H 1/00, G03H 1/26

(54) **Information storage in holograms**
Informationsspeicherung in Hologrammen
Stockage d'information dans des hologrammes

(30) Priority: 23.10.1989 US 425078
(43) Date of publication of application: 02.05.1991
(73) Proprietor: International Business Machines Corporation, Armonk, N.Y. 10504 (US)
(72) Inventor: Dube, Roger Raymond, Carmel, New York 10512 (US); Sarid, Uri, Cambridge, Massachusetts 02138 (US)
(74) Representative: Burt, Roger James, Dr.

(56) References cited:
- EP-A- 0 201 274
- GB-A- 2 203 854
- US-A- 3 627 401
- US-A- 3 798 618
- US-A- 4 012 108
- OPTICS AND SPECTROSCOPY, vol. 35, no. 2, August 1973, Washington, US, pp. 195-199 ; I.A. DERYUGIN ET AL.: 'Polarization contrast method in holography'

## Description

The present invention relates to holographic apparatus for storage and retrieval of information and to methods of information storage and retrieval using such holographic apparatus.

It is known that monochromatic light beams impinging upon photorefractive mediums, such as bismuth silicon oxide (BSO), when activated by a coherent reference beam, cause interference of the two monochromatic light beams within the medium. The light interference results in storage of data carried by the light beams as a volume hologram in a portion of the medium. Readout of the stored hologram is achieved by shining a reference light beam into the medium, causing the reference beam to be modulated by the stored hologram as it passes through the medium and leaves the medium along an output light path. It is known to superimpose holograms in a thick photorefractive medium, such as BSO.

The L. d'Auria et al. report in the periodical APPLIED OPTICS in an article entitled "Experimental Holographic Read-Write Memory Using 3-D Storage", Vol. 13 No. 4, April 1974, in pages 808-818 advises that holograms can be superimposed in a photorefractive record medium by rotating the reference beam. The rotation of the reference beam causes it to have differing angles of incidence on the input surface of the thick recording medium. As a result of the various angles of incidence of the reference beam, a plurality of holograms can be superimposed in the same volume of the record medium, one hologram corresponding to each angle of incidence. The stored hologram is readable by a readout reference beam aligned at the same angle of incidence used for recording the respective superimposed holograms. Such recording has required that the intensity of the pixels in the hologram is modulated to carry information. This use of intensity modulation is particularly subject to noise introduced into the signal by the optical paths of the light beams.

It is also known that a laser monochromatic light beam, in addition to carrying information based upon light intensity modulation, can carry information by means of differing angles of rotation of the plane of linear polarisation of the light beam with respect to a reference plane of linear light polarisation. Such rotation of the plane of polarisation results in P and S components, which are orthogonally disposed in the light beam. An example of such modulation is the readback light beam reflected from or transmitted through a magneto-optic record medium. The readback optics and electrical circuits for a magneto-optic record medium process the P and S components of the modulated reflected light beam for generating modulated output electrical signals wherein the modulations represent the information carried in the P and S components or rotated linear polarisation planes of such monochromatic laser light.

Many optical systems process light beams through polarisation sensitive beam splitters and other elements. An example of such light beam processing is shown in U. S. Patent 3,544,189 and 3,622,220. Accordingly, it is well known to separate the P and S components and to rotate the plane of linear polarisation of light beams for achieving various optical separation functions.

U. S. Patent 3,825,316 discloses a holographic system in which the polarisation of the light is switched in either of two directions for detection. According to this patent, a laser produces a beam of polarised coherent light which is transmitted through a polarisation switching device that adjusts, in response to an input signal, the orientation of the plane of polarisation of the transmitted light in either one of two mutually orthogonal states. The light transmitted by the polarisation switching device then impinges on a transparent electro-optic photorefractive crystaline material whose index of refraction along its C axis varies in accordance with the interference fringes of a pre-established holographic pattern. In one embodiment disclosed in this patent, the optical system includes an electro-optic beam deflector to provide a strong polarisation dependent digital laser beam deflection system such that the beam is deflected in a different predetermined direction depending upon the polarisation state of the beam, i.e. beam splitting. In another embodiment shown in this patent, the optical system includes a complex optical component to provide light deflection apparatus for selectively deflecting a beam of light from a source to one of a plurality of target positions.

The above references, with regard to holograms, show an intensity modulated beam for carrying information; it is also known that a single light beam carries information by rotational modulation of the linear light polarisation. U.S. Patent 3,627,401 discloses an information storage system, in which information is recorded by selectively orienting the plane of polarisation of the information beams. However, having regard to the prior art systems, it is desired to provide a more efficient holographic signal storage system with improved noise resistance.

Viewed from one aspect, the invention relates to a method of storing and retrieving information in a holographic record medium comprising the steps of:
providing an incident pixel array of light beams using substantially linearly polarised monochromatic light having a single reference angle of linear polarisation for all of the pixel light beams;
modulating the pixel light beams by rotating the linear polarisations of the respective pixel light beams in response to supplied information so that the information is represented by the respective angles of rotation of the linear polarisations of the light beams;
shining a reference beam onto the holographic record medium; and
directing the modulated pixel light beams as an array into said record medium and thereby into interference with the reference beam whereby the resultant interference pattern is recorded as a holographic image in the holographic record medium.

The invention relates to storing in a holographic medium, preferably as a volume hologram, information represented by any one of a plurality of angles of rotation of the plane of linear polarisation having two or more discrete angles of rotation from a reference plane of linear polarisation. All of the polarisation rotations are measured in the same rotational sense.

In order to improve the noise resistance, in the embodiments of the present invention a light beam, carrying information in the form of a plurality of angular rotational modulations of the plane of linear polarisation of a light beam, is stored as a plurality of images in a photorefractive medium. The storage of the images is arranged to be complementary so that imperfections in the medium are compensated for by the complementary storage. In a specific embodiment, the modulated light beams are stored as two different images having respective angular modulations separated by ninety degrees, i.e. orthogonal, as measured in a first or rotational direction from a reference plane of linear polarisation.

In the storage and readback of the two complementary images, signal processing within the storage system introduces the control of the polarisation rotation so that this rotation represents an input signal. The output signal of the two images are then divided one into another to produce a single modulated electrical output signal. The output signal is a faithful reproduction of the input modulation of a light beam. More than two images may be generated with the divisional function being applied between various pairs of the output signals.

Viewed from a second aspect, the invention provides information storage and retrieval apparatus comprising:
a source of substantially linearly polarised incident monochromatic light;
means for generating from source an array of pixel light beams, all having a single reference angle of linear polarisation;
means for selectively modulating the individual pixel light beams in accordance with supplied information so that the information is represented by the angular displacement of the plane of linear polarisation;
a holographic record medium located to receive said array of modulated pixel light beams; and
means for generating a reference beam and for directing said reference beam to interact with said modulated beams, the angle of linear polarisation of said reference beam being selected so as to generate an interference pattern with said modulated beams, thereby to record holographic images in said medium representing said array of modulated pixel light beams;
characterized by further comprising
means (15) for rotating the linear polarisations of all the said modulated pixel light beams by substantially 90° in the same rotational direction in order to form a complementary array of modulated pixel light beams for storage in said medium (10).

In order that the invention may be fully understood, a preferred embodiment thereof will now be described by way of example with reference to the accompanying drawings in which:
Fig 1 diagrammatically illustrates holographic apparatus in accordance with the present invention;
Fig 2 illustrates the operation of the apparatus shown in Fig 1 with respect to the effect of unintended intensity modulations of light beams being processed and stored;
Fig 3 is a diagrammatical plan view of a holographic storage medium showing reference and data pixel positions and forming part of the apparatus shown in Fig 1;
Fig 4 diagrammatically illustrates linear polarisation rotations for storing information in six discrete angular rotations from a reference linear polarisation which exemplifies one operation of the apparatus shown in Fig 1; and
Fig 5 is a simplified block diagram of read data circuits of the apparatus shown in Fig 1.

Referring now more particularly to the drawing, like numerals indicate like parts and structural features in the various figures. A photorefractive recording medium 10, such as BSO, is capable of storing volume holograms in superimposed relationships, that is, a plurality of holograms are stored in the same volume portion of the recording medium 10.

A laser 11 supplies a linearly polarised monochromatic light beam along a path 12 for flooding an input surface of an LCD (liquid crystal device) transmissive array 13. Input data supplied along line 14 controls the transmissive array 13 in the modulation of the laser 11 emitted linearly polarised light. The arrangement is such that at each pixel position in the array, the uniformly polarised light has its plane of linear polarisation rotated in a first rotational direction through an angle representative of the input data. One of the pixels in the array may be designated as a reference pixel, i.e. is not modulated. This enables a relative angular measurement between all of the data carrying pixels and the reference pixels. The light transmitted through array 13 is selectively passed through a one-half wave plate 15, also termed a phase plate. When phase plate 15 is in the light path, all of the linear polarisation modulations in the light beam are rotated by ninety degrees. When phase plate 15 is removed from the light path, as indicated by double headed arrow 16, then no rotation of the linear polarisation occurs. In an alternative embodiment, the phase plate may be positioned in the path of the linearly polarised monochromatic light beam 12 to achieve the same effect. The selective phase plate rotation of the linear polarisation planes enables two complementary holographic images to be stored in BSO crystal 10; one holographic image that is not complementarily rotated and a second which is stored with its plane of linear polarisation rotated by 90 degrees. For speeding the operation of the mechanical movement of the phase plate 15, a plurality of phase plates may be inserted onto a rapidly rotating circular disk, much like a tachometer disk, such that alternate areas on the disk rotate the light beam polarisation by ninety degrees with the intermediate areas not rotating the light beam. That is, the rotating disk has a plurality of circumferentially spaced-apart phase plates. As the disk rotates, the light beam is transmitted, with no rotation of the plane of polarisation, through the intermediate area and alternatively with 90 degrees rotation through the phase plate area. Other arrangements, including electrically actuated rotations may be employed for achieving the construction of two complementary holograms. From the phase plate position, either with the phase plate 15 in the light path or out of the light path, the modulated light passes through a polariser 17, then impinges upon the input surface of BSO record medium 10. A reference beam 20 is supplied to the input surface of the BSO crystal 10 to record the modulated light beam as a volume hologram. In a preferred form, the non-phase plate rotated beam is first recorded in the BSO crystal, then the phase plate 15 moves into optical interceptive relationship to the laser beam to rotate the laser beam creating a complementary volume hologram in the BSO crystal 10. Note that for this complementary hologram, the reference beam 20 is rotated to impinge on the BSO crystal 10 at an orthogonal angle of polarisation relative to that at which the first hologram was recorded. To obtain a plurality of pairs of volume holograms, reference beam 20 may be rotated such that different angles of incidence on the input surface of BSO crystal 10 are achieved.

To read out the recorded volume holograms, reference beam 20 shines upon the input surface of BSO crystal 10 without any input from laser 11. The reference beam is positioned at an angle to read the first hologram. The first hologram modulates the reference beam to supply an output set of laser beams (these beams are a reconstructed image of the stored information) which impinge upon an array of detectors 21. The second (complementary) hologram was stored at an orthogonal polarisation from the first hologram. To read the second hologram, the reference beam is rotated to the orthogonal polarisation; the read out (reconstruction) proceeds as described for the first hologram. The two reconstructed images are sequentially supplied to detectors 21 and therefore are sequentially supplied to read data circuits 22. As later described, read data circuits 22 supply an output signal through cable 23 by combining the two images through a divisional processing circuit for reconstructing the information carried by the modulation imposed upon the light beam in transmissive array 13. Output data (electrical signals) indicated by output cable 23, as will be later described, provide more faithful information reproduction.

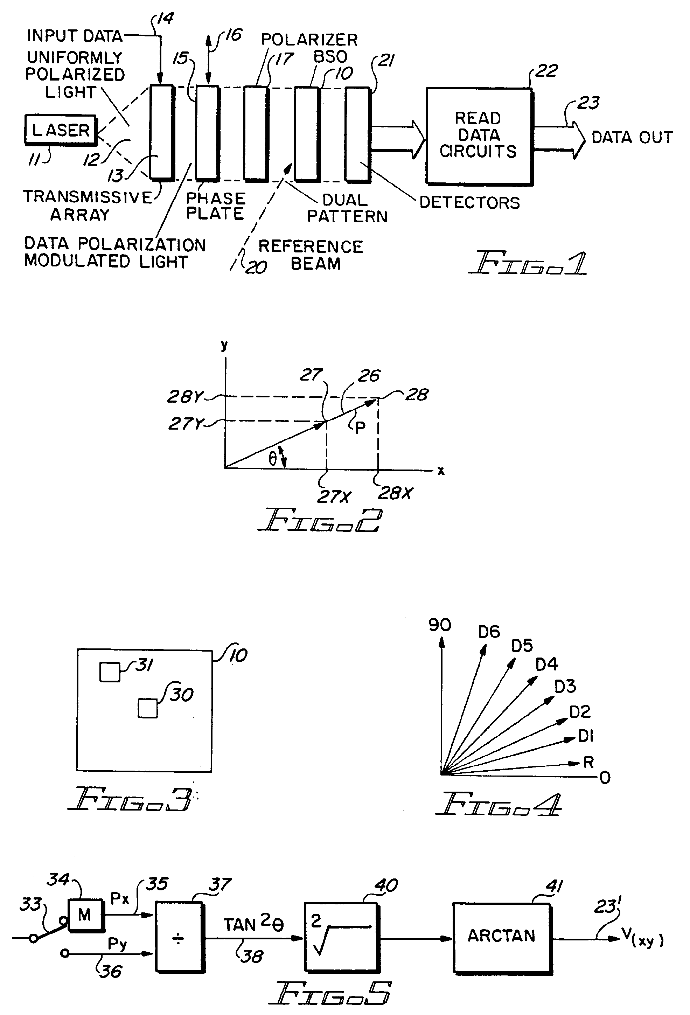

Fig 2 illustrates an advantage of the present invention. A first angle of rotation represented by the arrow 26 represents the encoding of input data. The arrow is shown to have two lengths 27, 28 which respectively represent two unintended intensity levels of the laser beam. In the recording scheme described herein, this information is stored as two complementary images. The first image, without the phase plate, stores an image whose intensity is determined by the length of the component 27X or 28X of the arrow 26 two image intensities. Following the recording sequence described earlier, a phase plate is inserted into the beam, the reference angle is rotated to the orthogonal polarisation, and a second image is recorded. The function of the phase plate is to rotate the arrows (representing the polarisation) by 90 degrees, so that the second image stored now records projections 27Y and 28Y, respectively, for the two intensities of the laser beam. Upon readout, the ratio stored y component over stored x component is the tangent of the angle ϑ enabling the angle ϑ to be determined. If this process were to occur under different intensity conditions as represented by numerals 27 and 28, there is no noise effect on the information retrieval. In this manner, the described storage process provides insensitivity to unintended variations in light intensity.

Fig 3 illustrates, in diagrammatic form, a polarisation rotation reference system for faithfully indicating the recorded information. A centrally located pixel 30 is unmodulated and therefore represents the reference polarisation location for all of the pixels in the array being stored. Each data carrying pixel, such as pixel 31 (there are many such data carrying pixels), is modulated in accordance with the input data on line 14. From Fig 3 it is apparent that if an optical element causes an unintended rotation of the linear polarisation of the multi-pixel light beam, then such unintended linear polarisation rotation will be substantially constant through out the beam and hence, can be accomodated through the use of a reference pixel 30.

Fig 4 illustrates angular representation of information at a single pixel. Six different angles of rotation are shown, all being in a counterclockwise rotational sense from a reference angle of rotation R. The various vectors, D1-D6, represent the six angular positions. Such six angular positions of rotated linear polarisations can be encoded to represent six different bits, can be a number to the base six, or can be a encoded number in binary form to the sixth power. The length of the arrows represents the vector intensity which, of course, is projected by the polariser onto one of the two coordinate axes. The angular rotations can extend from zero up to and including 90 degrees.

Fig 5 shows an embodiment of data read circuits 22 for detecting the information carried on input data line 14 from the volume hologram stored in record medium 10. This figure illustrates a so-called post processing arrangement for introducing the arc tangent of square root parameter into the signal detection processing. Electrical signals from detectors 21 are in array form, Fig 5 illustrates only one circuit for one pixel. A signal from a detector 21 is supplied through an electronic switch 33. The first image reconstructed by the reference beam 20 is supplied to a memory M 34. Switch 33 then moves to the alternate terminal to enable processing of the second or complementary signal. When the second image is reconstructed by reference beam 20, circuits (not shown) actuate the switch 33 in synchronism with the transmission of the electrical signal from the same detector 21 such that the signals on lines 35 and 36, respectively, represent electrical signals derived from the first and second (complementary) image pixels of the recording medium 10. Divide circuit 37, which may be either analog or digital, divides the signal Py, the first recorded signal with no complementary rotation, by the second signal Px, which represents the stored signal rotated by ninety degrees through phase plate 15. The output signal of divide circuit 37 carries the electrically modulated signal representative of TAN²ϑ on line 38. Circuit elements 40 and 41 introduce the arc tangent of square root into the read back signal for producing a signal on line 23′, which is a true reproduction of the input modulation carried by input data on line 14. Final reproduction of the data is provided by a lookup table (not shown) storing values representing the above-described function. Circuit 40 is a typical square root circuit, while circuit 41 is a typical arctan circuit.

Explaining the operation of Fig 1, the projection of the polarisation vectors, or their squares, along two non-colinear axes, typically orthogonally disposed axes, results in two separate holograms. If the intensity of the image before the polariser 17 is indicated by I(x,y) and the polarisation angle by ϑ (x,y) then the stored patterns within BSO crystal 10 are given by:$\text{(1) Px (x,y) = I(x,y) COS² ϑ (x,y)}$$\text{(2) Py (x,y) = I(x,y) SIN² ϑ (x,y)}$

In the above equations, the letter "P" indicates the stored pattern or hologram. Note that the signal is embodied in ϑ (x,y) not in I (x,y) which in general suffers from non-uniformities in the laser, the optical path, and the storage medium. Upon readout, information further unintended intensity non-uniformities may be produced. Thus the patterns read out may be of the form in equations (3) and (4).$\text{(3) Px′ (x,y) = I′(x,y) COS² ϑ (x,y)}$$\text{(4) Py′ (x,y) = I′(x,y) SIN² ϑ (x,y)}$

To recover the original information, the two images are divided into each other on a pixel-by-pixel basis yielding an intermediate result, as represented by the signal on line 38. This output signal is independent of any noise in I′ (x,y) induced into the reconstructed patterns. The post processing shown in Fig 5 of the square root and arctangent yields a modulated electrical signal carrying the information.

It can thus be seen that by storing complementary images derived from the same information, the effect of the noise inducing parameters of the recording medium as well as non-uniformities in the optical path and laser beam can be accomodated.

## Claims

1. A method of storing and retrieving information in a holographic record medium comprising the steps of:
producing an array of incident pixel light beams using substantially linearly polarised monochromatic light having a single reference angle of linear polarisation for all of the pixel light beams;
modulating the pixel light beams by rotating the linear polarisations of the respective pixel light beams in response to supplied information so that the information is represented by the respective angles of rotation of the linear polarisations of the light beams;
recording a holographic image of said array of modulated pixel light beams by shining a reference beam onto the holographic record medium; and by
directing the modulated pixel light beams as an array onto said record medium and thereby into interference with the reference beam whereby the resultant interference pattern is recorded as a holographic image in the holographic record medium,
characterized by
the steps of:
after the said holographic image has been recorded, rotating the linear polarisations of all the said modulated pixel light beams by substantially 90° in the same rotational direction to form a complementary array of pixel light beams; and
repeating said recording step for the complementary array of pixel light beams.

2. A method of storing and retrieving information as claimed in Claim 1 wherein the images corresponding to the ordinary array and the complementary pixel array are recorded as holograms in substantially the same volumetric portion of the record medium as each other.

3. A method of storing and retrieving information as claimed in any of Claims 1 or 2, further comprising retrieving the stored information by the steps of:
optically sensing the stored images of the ordinary and complementary arrays in order to produce sets of ouput data in the form of electrical signals representative of the light intensity of the pixel light beams of the ordinary and complementary arrays respectively; and
dividing signals for one set of output data by the corresponding signals forming the other set of output data thereby to produce a further set of output data representative of said supplied information.

4. A method as claimed in Claim 3 wherein the supplied information represented by the rotation of the angle of polarisation of the modulated pixel light beam is determined from said further set of output data by calculating the arc tangent of the square root of each signal in the set.

5. A method of storing and retrieving information as claimed in any preceding claim wherein the modulation step comprises the steps of:
designating one of the pixel light beams as a reference pixel beam and modulating the linear polarisation of the reference pixel light beam to be a predetermined angle from the incident reference angle of polarisation; and
modulating all other pixel light beam linear polarisations by angles representative of supplied information, measured with respect to the predetermined angle of the reference pixel light beam.

6. A method of storing and retrieving information as claimed in any preceding claim wherein the modulation step further comprises the step of:
selectively and independently rotating the linear polarisation of said pixel beams respectively by more than one angle of linear polarisation rotation such that the beams at each pixel position are rotated by an angle of rotation being selectable from two or more different angles, such that two or more signal states may be recorded in each pixel position of the holographic image.

7. Information, storage and retrieval apparatus comprising:
a source (11) of substantially linearly polarised incident monochromatic light;
means for generating from said source an array of pixel light beams, all having a single reference angle of linear polarisation;
means (13) for selectively modulating the individual pixel light beams in accordance with supplied information so that the information is represented by the angular displacement of the plane of linear polarisation;
a holographic record medium (10) located to receive said array of modulated pixel light beams; and
means for generating a reference beam (20) and for directing said reference beam to interact with said modulated beams, the angle of linear polarisation of said reference beam being selected so as to generate an interference pattern with said modulated beams thereby to record holographic images in said medium (10) representing said array of modulated pixel light beams;
characterized by
further comprising means (15) for rotating the linear polarisations of all the said modulated pixel light beams by substantially 90° in the same rotational direction in order to form a complementary array of pixel light beams for storage in said medium.

8. Information, storage and retrieval apparatus as claimed in Claim 7 wherein said means (15) for rotating the linear polarisations of all of the said modulated pixel light beams include a phase plate movably disposed with respect to said pixel light beams such that the pixel light beams have or do not have their respective linear polarisations rotated by said phase plate; and
translation means in said control means movably supporting the phase plate for moving the phase plate between pixel light beam intercepting and pixel light beam avoiding positions.

9. Information, storage and retrieval apparatus as claimed in Claim 7 or 8, further comprising:
means (21) for optically sensing the stored images corresponding to the ordinary and complementary arrays in order to produce sets of output data in the form of electrical signals representative of the light intensity of the pixel light beams of the ordinary and complementary arrays respectively; and
means for dividing signals for one set of output data by the corresponding signals forming the other set of data, thereby to produce a further set of output data representative of said supplied information.

10. Information, storage and retrieval apparatus as claimed in Claim 7, further comprising means (37) for determining the supplied information represented by the rotation of angle of polarisation of the modulated pixel light beam from said further said output data by calculating the arc tangent of the square root of each signal in the set.

11. Information, storage and retrieval apparatus as in any of Claims 7 to 11 wherein the means (13) for modulating the said pixel light beams comprises a transmissive array of pixels which, when acted on by said polarised light, causes the linear polarisations to be rotated in response to an input information data signal thereby generating modulated pixel light beams.

12. Information, storage and retrieval apparatus as claimed in any of Claims 7 to 11 comprising means defining one of the said pixel light beams as a reference pixel beam.

## Patentansprüche

1. Verfahren zum Speichern und Wiederauffinden von Information in einem holographischen Aufzeichnungsmedium, umfassend die Schritte des:
Erzeugens einer Gruppe von einfallenden Rasterpunkt-Lichtstrahlen unter Benutzen von im wesentlichen linear polarisiertem, monochromatischem Licht, das einen einzigen Bezugswinkel der linearen Polarisation für alle Rasterpunkt-Lichtstrahlen aufweist,
Modulierens der Rasterpunkt-Lichtstrahlen durch Drehen der linearen Polarisationen der betreffenden Rasterpunkt-Lichtstrahlen entsprechend gelieferter Information, so daß die Information durch die entsprechenden Drehwinkel der linearen Polarisationen der Lichtstrahlen dargestellt wird,
Aufzeichnens eines holographischen Bildes der Gruppe der modulierten Rasterpunkt-Lichtstrahlen durch Ausstrahlen eines Bezugsstrahls auf das holographische Aufzeichnungsmedium und
des Richtens der modulierten Rasterpunkt-Lichtstrahlen als eine Gruppe auf das Aufzeichnungsmedium und dadurch in die Interferenz mit dem Bezugsstrahl, wodurch das erhaltene Interferenzmuster als ein holographisches Bild in dem holographischen Aufzeichnungsmedium aufgezeichnet wird,
gekennzeichnet durch die Schritte des:
nach dem Aufzeichnen des holographischen Bildes erfolgenden Drehens der linearen Polarisationen all der modulierten Rasterpunkt-Lichtstrahlen um im wesentlichen 90° in der gleichen Drehrichtung, um eine komplementäre Gruppe von Rasterpunkt-Licht-Lichtstrahlen zu bilden, und
des Wiederholens des Aufzeichnungsschrittes für die komplementäre Gruppe der Rasterpunkt-Lichtstrahlen.

2. Verfahren zum Speichern und Wiederauffinden von Information nach Anspruch 1, bei dem die Bilder, die der regulären Gruppe und der komplementären Rasterpunkt-Gruppe entsprechen, als Hologramme in im wesentlichen dem gleichen volumetrischen Teil des Aufzeichnungsmediums aufgezeichnet werden wie die jeweils anderen.

3. Verfahren zum Speichern und Wiederauffinden von Information nach irgendeinem der Ansprüche 1 oder 2, weiter umfassend das Wiederauffinden der gespeicherten Information durch die Schritte des:
optischen Abfühlens der gespeicherten Bilder der regulären und komplementären Gruppen, um einen Satz von Ausgangsdaten in der Form elektrischer Signale zu erzeugen, die für die Lichtintensität der Rasterpunkt-Lichtstrahlen der regulären und komplementären Gruppen repräsentativ sind, und
des Dividierens der Signale für einen Satz von Ausgangsdaten durch die entsprechenden Signale, die den anderen Satz von Ausgangsdaten bilden, um dadurch einen weiteren Satz von Ausgangsdaten zu erzeugen, der für die gelieferte Information repräsentativ ist.

4. Verfahren nach Anspruch 3, bei dem die gelieferte Information, die durch die Drehung des Polarisationswinkels des modulierten Rasterpunkt-Lichtstrahles dargestellt wird, aus dem weiteren Satz von Ausgangsdaten bestimmt wird durch Berechnen des Arkustangens-Wertes der Quadratwurzel jedes Signales in dem Satz.

5. Verfahren zum Speichern und Wiederauffinden von Information nach irgendeinem vorhergehenden Anspruch, bei dem der Modulationsschritt die Schritte umfaßt des:
Auswählens eines der Rasterpunkt-Lichtstrahlen als Bezugs-Rasterpunkt-Lichtstrahl und des Modulierens der linearen Polarisation des Bezugs-Rasterpunkt-Lichtstrahles, so daß er einen vorgegebenen Winkel zu dem als Bezug dienenden Einfallswinkel der Polarisation aufweist, und
des Modulierens aller anderen linearen Polarisationen der Rasterpunkt-Lichtstrahlen durch Winkel, die die gelieferte Information repräsentieren, gemessen bezüglich des vorgegebenen Winkels des Bezugs-Rasterpunkt-Lichtstrahls.

6. Verfahren zm Speichern und Wiederauffinden von Information nach irgendeinem vorhergehenden Anspruch, bei dem der Modulationsschritt weiter den Schritt umfaßt des:
selektiven bzw. unabhängigen Drehens der linearen Polarisation der Rasterpunkt-Lichtstrahlen um mehr als einen Winkel der linearen Polarisationsdrehung, so daß die Strahlen an jeder Rasterpunkt-Position um einen Drehwinkel gedreht werden, der aus zwei oder mehr verschiedenen Winkeln auswählbar ist, so daß zwei oder mehr Signalzustände in jeder Rasterpunkt-Position des holographischen Bildes aufgezeichnet werden können.

7. Gerät zum Speichern und Wiederauffinden von Information, umfassend:
eine Quelle (11) von im wesentlichen linear polarisiertem, einfallenden monochromatischen Licht,
Mittel zum Erzeugen einer Gruppe von Rasterpunkt-Lichtstrahlen aus der Quelle, die alle einen einzigen Bezugswinkel der linearen Polarisation aufweisen,
Mittel (13) zum selektiven Modulieren der einzelnen Rasterpunkt-Lichtstrahlen gemäß gelieferter Information, so daß die Information durch die Winkelverschiebung der Ebene der linearen Polarisation dargestellt wird,
ein holographisches Aufzeichnungsmedium (10), das angeordnet ist, um die Gruppe modulierter Rasterpunkt-Lichtstrahlen zu empfangen und
Mittel zum Erzeugen eines Referenzstrahles (20) und zum Richten des Referenzstrahles, so daß er mit den modulierten Strahlen in Wechselwirkung tritt, wobei der Winkel der linearen Polarisation des Bezugsstrahles so ausgewählt wird, daß er ein Interferenzmuster mit den modulierten Strahlen erzeugt, um dadurch holographische Bilder in dem Medium (10) aufzuzeichnen, die die Gruppe von modulierten Rasterpunkt-Lichtstrahlen darstellen,
gekennzeichnet durch das weitere Umfassen von Mitteln (15) zum Drehen der linearen Polarisationen all der modulierten Rasterpunkt-Lichtstrahlen um etwa 90° in der gleichen Drehrichtung, um eine komplementäre Gruppe von Rasterpunkt-Lichtstrahlen für das Speichern in dem Medium zu bilden.

8. Gerät zum Speichern und Wiederauffinden nach Anspruch 7, bei dem die Mittel (15) zum Drehen der linearen Polarisationen all der modulierten Rasterpunkt-Lichtstrahlen eine Phasenplatte einschließen, die im Hinblick auf die Rasterpunkt-Lichtstrahlen beweglich so angeordnet ist, daß die entsprechenden linearen Polarisationen der Rasterpunkt-Lichtstrahlen durch die Phasenplatte gedreht werden oder nicht, und
Bewegungsmittel in den Steuermitteln zum beweglichen Unterstützen der Phasenplatte zur Bewegung der Phasenplatte zwischen den Rasterpunkt-Lichtstrahl aufnehmenden und den Rasterpunkt-Lichtstrahl vermeidenden Positionen.

9. Gerät zum Speichern und Wiederauffinden von Information nach Anspruch 7 oder 8, weiter umfassend:
Mittel (21) zum optischen Abfühlen der gespeicherten Bilder, die den regulären und komplementären Gruppen entsprechen, um Sätze von Ausgangsdaten in der Form elektrischer Signale zu erzeugen, die die Lichtintensität der Rasterpunkt-Lichtstrahlen der regulären bzw. komplementären Gruppen repräsentieren, und
Mittel zum Dividieren der Signale für einen Satz von Ausgangdaten durch die entsprechenden Signale, die den anderen Satz von Ausgangsdaten bilden, um dadurch einen weiteren Satz von Ausgangsdaten zu erzeugen, der repräsentativ für die gelieferte Information ist.

10. Gerät zum Speichern und Wiederauffinden von Information nach Anspruch 7, weiter umfassend Mittel (37) zum Bestimmen der gelieferten Information, die durch die Drehung des Polarisationswinkels des modulierten Rasterpunkt-Lichtstrahls aus den weiteren Ausgangsdaten durch Berechnen des Arkustangens-Wertes der Quadratwurzel jedes Signales in dem Satz dargestellt wird.

11. Gerät zum Speichern und Wiederauffinden von Information nach irgeneinem der Ansprüche 7 bis 11, bei dem das Mittel (13) zum Modulieren der Rasterpunkt-Lichtstrahlen
eine durchlässige Gruppe von Rasterpunkten aufweist, die, wenn das polarisierte Licht auf sie einwirkt, veranlaßt, daß die linearen Polarisationen als Antwort auf ein Datensignal der Eingangsinformation gedreht werden, wodurch modulierte Rasterpunkt-Lichtstrahlen erzeugt werden.

12. Gerät zum Speichern und Wiederauffinden von Information nach irgendeinem der Ansprüche 7 bis 11, umfassend Mittel, die einen der Rasterpunkt-Lichtstrahlen als einen Bezugs-Rasterpunkt-Lichtstrahl definieren.

## Revendications

1. Procédé pour stocker et récupérer des informations dans un support d'enregistrement holographique comportant les étapes consistant à :
produire un réseau de faisceau lumineux incidents de pixels en utilisant la lumière monochromatique polarisée de manière pratiquement linéaire, ayant un seul angle de référence de polarisation linéaire pour la totalité des faisceaux lumineux pixels,
moduler les faisceaux lumineux de pixels en faisant tourner les polarisations linéaires des faisceaux lumineux de pixels respectifs en réponse aux informations délivrées de sorte que les informations soient représentées par les angles respectifs de rotation des polarisations linéaires des faisceaux lumineux,
enregistrer une image holographique dudit réseau de faisceaux lumineux de pixels modulés en projetant un faisceau de référence sur le support d'enregistrement holographique, et en orientant les faisceaux lumineux de pixels modulés en réseau sur ledit support d'enregistrement et donc en interférence avec le faisceau de référence d'où il résulte que le motif d'interférence obtenu est enregistré sous la forme d'une image holographique sur le support d'enregistrement holographique,
caractérisé par les étapes consistant à :
après que ladite image holographique ait été enregistrée, faire tourner les polarisations linéaires de la totalité des faisceaux lumineux de pixels modulés de pratiquement 90° dans le même sens de rotation de façon à former un réseau complémentaire de faisceaux lumineux de pixels, et
répéter ladite étape d'enregistrement pour le réseau complémentaire de faisceaux lumineux de pixels.

2. Procédé pour stocker et récupérer des informations selon la revendication 1, dans lequel les images correspondant au réseau ordinaire et au réseau de pixels complémentaire sont enregistrées comme des hologrammes avec pratiquement le même encombrement en volume du support d'enregistrement pour les deux réseaux.

3. Procédé pour stocker et récupérer des informations selon l'une des revendications 1 ou 2, comprenant de plus la récupération des informations stockées par les étapes consistant à :
détecter optiquement les images stockées des réseaux ordinaire et complémentaire afin de produire des ensembles de données de sortie sous la forme de signaux électriques représentatifs de l'intensité lumineuse des faisceaux lumineux de pixels des réseaux ordinaire et complémentaire, respectivement, et
diviser les signaux d'un ensemble de données de sortie par les signaux correspondants formant l'autre ensemble de données de sortie pour produire de ce fait un autre ensemble de données de sortie représentatif desdites informations délivrées.

4. Procédé selon la revendication 3, dans lequel les informations délivrées représentées par la rotation de l'angle de polarisation de faisceau lumineux de pixels modulé sont déterminées à partir dudit autre ensemble de données de sortie en calculant l'arc tangente de la racine carrée de chaque signal de l'ensemble.

5. Procédé pour stocker et récupérer des informations selon l'une quelconque des revendications précédentes, dans lequel l'étape de modulation comprend les étapes consistant à :
désigner un des faisceaux lumineux de pixels comme un faisceau de pixels de référence et moduler la polarisation linéaire du faisceau lumineux de pixels de référence pour qu'il soit à un angle prédéterminé par rapport à l'angle de polarisation de référence incident, et
moduler la totalité des autres polarisations linéaires des faisceaux lumineux de pixels par des angles représentatifs des informations délivrées, mesurés par rapport à l'angle prédéterminé du faisceau lumineux de pixels de référence.

6. Procédé pour stocker et récupérer des informations selon l'une quelconque des revendications précédentes, dans lequel l'étape de modulation comprend de plus l'étape consistant à :
faire tourner sélectivement et indépendamment la polarisation linéaire desdits faisceaux de pixels respectivement sur plus d'un angle de rotation de polarisation linéaire de sorte que les faisceaux à chaque position de pixels soient tournés d'un angle de rotation qui peut être sélectionné à partir de deux angles différents ou plus, de sorte que deux états de signal ou plus peuvent être enregistrés pour chaque position de pixel de l'image holographique.

7. Dispositif de stockage et de récupération d'informations comprenant :
une source (11) de lumière monochromatique incidente polarisée pratiquement linéairement,
un moyen pour produire à partir de ladite source un réseau de faisceaux lumineux de pixels, ayant tous un seul angle de référence de polarisation linéaire,
un moyen (13) pour moduler sélectivement les faisceaux lumineux de pixels individuels conformément aux informations délivrées de sorte que les informations soient représentées par le décalage angulaire du plan de polarisation linéaire,
un support d'enregistrement holographique (10) placé de manière à recevoir ledit réseau de faisceaux lumineux de pixels modulés, et
un moyen pour produire un faisceau de référence (20) et pour orienter ledit faisceau de référence de façon à ce qu'il interagisse avec lesdits faisceaux modulés, l'angle de polarisation linéaire dudit faisceau de référence étant choisi de façon à produire un motif d'interférence avec lesdits faisceaux modulés, pour enregistrer de ce fait les images holographiques sur ledit support (10) représentant ledit réseau de faisceaux lumineux de pixels modulés,
caractérisé par
en ce qu'il comprend de plus un moyen (15) pour faire tourner les polarisations linéaires de la totalité desdits faisceaux lumineux de pixels modulés sur pratiquement 90° dans le même sens de rotation afin de former un réseau complémentaire de faisceaux lumineux de pixels pour le stocker sur ledit support.

8. Dispositif de stockage et de récupération d'informations selon la revendication 7, dans lequel ledit moyen (15) pour faire tourner les polarisations linéaires de la totalité desdits faisceaux lumineux de pixels modulés comporte une lame de phase disposée de manière mobile par rapport auxdits faisceaux lumineux de pixels de sorte que lesdits faisceaux lumineux de pixels subissent ou non une rotation de leurs polarisations linéaires respectives par ladite lame de phase, et
un moyen de translation dans ledit moyen de commande, supportant de manière mobile la lame de phase, pour déplacer la lame de phase entre des positions interceptant le faisceau lumineux de pixels et évitant le faisceau lumineux.

9. Dispositif de stockage et de récupération d'informations selon la revendication 7 ou 8, comprenant de plus :
un moyen pour détecter optiquement les images stockées correspondant aux réseaux ordinaire et complémentaire afin de produire des ensembles de données de sortie sous la forme de signaux électriques représentatifs de l'intensité lumineuse des faisceaux lumineux de pixels des réseaux ordinaire et complémentaire, respectivement, et
un moyen pour diviser les signaux d'un ensemble de données de sortie par les signaux correspondants formant l'autre ensemble de données de sortie, afin de produire de ce fait un autre ensemble de données de sortie représentatif desdites informations délivrées.

10. Dispositif de stockage et de récupération d'informations selon la revendication 7, comprenant de plus un moyen (37) pour déterminer les informations délivrées représentées par la rotation de l'angle de polarisation du faisceau lumineux de pixels modulé à partir desdites autres données de sortie en calculant l'arc tangente de la racine carrée de chaque signal de l'ensemble.

11. Dispositif de stockage et de récupération d'informations selon l'une quelconque des revendications 7 à 11, dans lequel le moyen (13) pour moduler lesdits faisceaux lumineux de pixels comprend un réseau transmissif de pixels qui, lorsque activé par ladite lumière polarisée, amène les polarisations linéaires à tourner en réponse à un signal de données d'informations d'entrée produisant de ce fait des faisceaux lumineux de pixels modulés.

12. Dispositif de stockage et de récupération d'informations selon l'une quelconque des revendications 7 à 11, comprenant un moyen définissant un desdits faisceaux lumineux de pixel en tant que faisceau de pixels de référence.
